# EUROPEAN PATENT APPLICATION

(11) **EP 3 651 556 A1**
(43) Date of publication of application: **13.05.2020**
(21) Application number: 17921017.4
(22) Date of filing: 11.08.2017
(51) Int. Cl.: H05K 1/11

(54) **PRINTED CIRCUIT BOARD AND TERMINAL**

(71) Applicant: Huawei Technologies Co., Ltd., Longgang District Shenzhen, Guangdong 518129 (CN)
(72) Inventor: LIU, Liping, Shenzhen, Guangdong 518129 (CN); GU, Rihui, Shenzhen, Guangdong 518129 (CN); PANG, Jia, Shenzhen, Guangdong 518129 (CN)
(74) Representative: MERH-IP Matias Erny Reichl Hoffmann Patentanwälte PartG mbB
(86) International application number: PCT/CN2017/097269
(87) International publication number: WO 2019/028913

(57) **Abstract**

A printed circuit board and a terminal are disclosed and relate to the field of terminal technologies. A printed circuit board includes a circuit board body (1) and a solder pad row (2) disposed on a back of the circuit board body (1). The solder pad row (2) includes a solder thief pad (4) and a plurality of pin solder pads (3). The plurality of pin solder pads (3) and the solder thief pad (4) are successively disposed at intervals in a first direction (K₁). The pin solder pads (3) are round. An outline of an edge (5), on the solder thief pad (4), that is close to the plurality of pin solder pads (3) is an arc concave toward the solder thief pad (4). In this way, on the premise that an interstice width (Di) between a middle part of the solder thief pad (4) and an end pin solder pad (A) in a second direction (K₂) remains unchanged, an interstice between either of two ends of the solder thief pad (4) in the second direction (K₂) and the end pin solder pad (A) is reduced, so that the solder thief pad (4) can effectively attract soldering tin on the end pin solder pad (A). This reduces a possibility of generating soldering tin paste between the end pin solder pad (A) and an adjacent pin solder pad (3) in a same row, and between the end pin solder pad (A) and a pin solder pad (3) in an adjacent row, and avoids a short circuit on the printed circuit board.

## Description

### TECHNICAL FIELD

This application relates to the field of terminal technologies, and in particular, to a printed circuit board and a terminal.

### BACKGROUND

In a wave soldering technology, a melted soft solder paste is blown into a solder wave required in design, and a printed circuit board on which a component is installed in advance is enabled to pass through the solder wave, so that a component pin is soldered onto a solder pad on the printed circuit board.

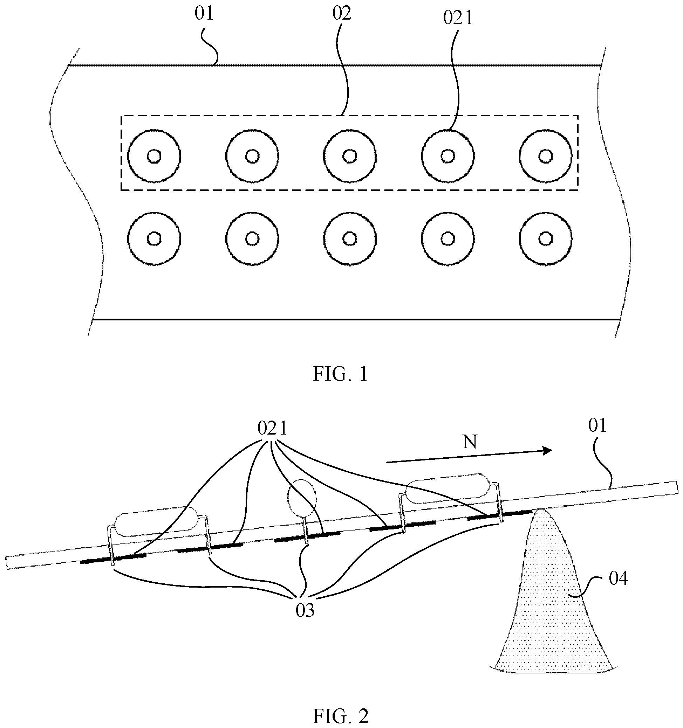

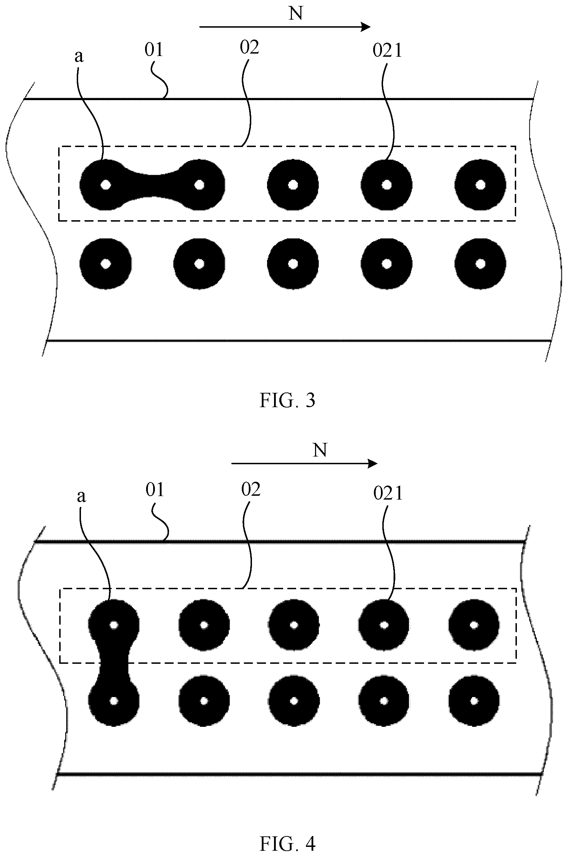

FIG. 1 shows a printed circuit board in the prior art. The printed circuit board includes a circuit board body 01 and a pin solder pad row 02 disposed on a back of the circuit board body 01. The pin solder pad row 02 includes a plurality of pin solder pads 021 arranged along a straight line. As shown in FIG. 2, when a plurality of component pins 03 are respectively soldered onto the plurality of pin solder pads 021 by using wave soldering technology, melted soldering tin may be blown into a solder wave 04 required in design, and the circuit board body 01 is enabled to move upward in an extension direction of the pin solder pad row 02 at a tilt angle of 6° to 8° (namely, in a direction N shown in FIG. 2), to pass through the solder wave 04. In this way, the plurality of pin solder pads 021 in the pin solder pad row 02 successively enter the solder wave 04. A pin solder pad 021 exerts acting force on soldering tin on a former pin solder pad 021 in a direction opposite to the moving direction, to prevent soldering tin from accumulating on the former pin solder pad 021. If a last pin solder pad 021 that enters the solder wave 04 in the plurality of pin solder pads 021 is defined as an end pin solder pad a, no acting force is exerted on the end pin solder pad a. Consequently, soldering tin is likely to accumulate on the end pin solder pad a, and soldering tin paste (as shown in FIG. 3 and FIG. 4) is easily generated between the end pin solder pad a and an adjacent pin solder pad in a same row, and between the end pin solder pad a and a pin solder pad in an adjacent row, resulting in a short circuit.

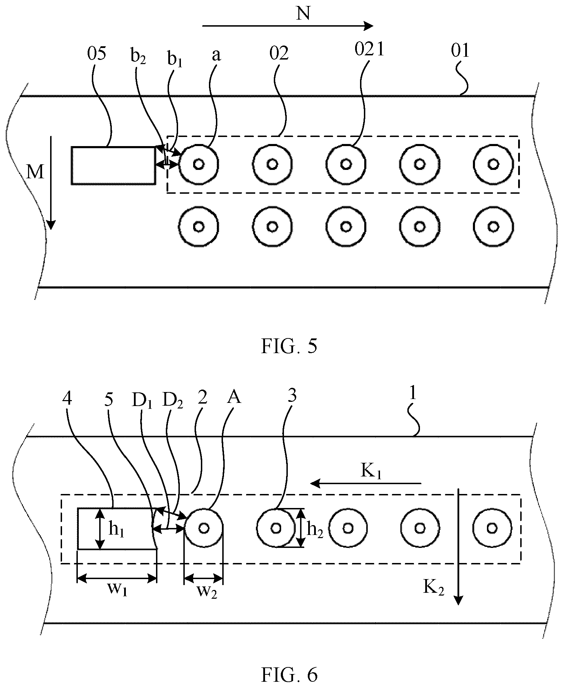

To avoid this problem, in the prior art, as shown in FIG. 5, a solder thief pad 05 is usually disposed on the circuit board at an end of the pin solder pad row 02 in the direction N for passing boards for wave soldering. The solder thief pad 05 exerts acting force on soldering tin on the end pin solder pad a in a direction opposite to the direction N for passing boards for wave soldering, to prevent soldering tin from accumulating on the end pin solder pad a. This reduces a possibility of generating soldering tin paste between the end pin solder pad a and the adjacent pin solder pad in the same row, and between the end pin solder pad a and the pin solder pad in the adjacent row, and avoids a short circuit on the printed circuit board.

However, in the printed circuit board shown in FIG. 5, the solder thief pad 05 is rectangle. An outline of an edge, on the solder thief pad 05, that is close to the end pin solder pad a is a straight line, but the pin solder pads 021 are round. If a direction that is perpendicular to an arrangement direction of the plurality of pin solder pads 021 and that is parallel to the back of the circuit board body is defined as a width direction M, an interstice width between either of two ends of the solder thief pad 05 in the width direction M and the end pin solder pad a is a first width bi, and an interstice width between a middle part of the solder thief pad 05 in the width direction M and the end pin solder pad a is a second width b₂, the first width bi is greater than the second width b₂. Therefore, during wave soldering, the two ends of the solder thief pad 05 in the width direction M exert relatively weak acting force on the end pin solder pad a, and soldering tin on the end pin solder pad a cannot be effectively attracted to the solder thief pad 05. As a result, excessive soldering tin remains on the end pin solder pad a. Consequently, soldering tin paste is still generated between the end pin solder pad a and the adjacent pin solder pad in the same row, and between the end pin solder pad a and the pin solder pad in the adjacent row, and a possibility of a short circuit on the printed circuit board is still high.

### SUMMARY

Embodiments of this application provide a printed circuit board and a terminal, to reduce a possibility of generating soldering tin paste between an end pin solder pad and an adjacent pin solder pad in a same row, and between the end pin solder pad and a pin solder pad in an adjacent row, so that a short circuit on the printed circuit board is avoided.

To achieve the foregoing objective, the following technical solutions are used in the embodiments of this application.

According to a first aspect, this application provides a printed circuit board, including a circuit board body and a solder pad row disposed on a back of the circuit board body. The solder pad row includes a solder thief pad and a plurality of pin solder pads. The plurality of pin solder pads and the solder thief pad are successively disposed at intervals in a first direction. The pin solder pads are round. An outline of an edge, on the solder thief pad, that is close to the plurality of pin solder pads is an arc concave toward the solder thief pad.

It should be noted that, to facilitate the following analysis and description, a pin solder pad closest to the solder thief pad in the plurality of pin solder pads is defined as an end pin solder pad. In addition, a direction perpendicular to the first direction and parallel to the back of the circuit board body is defined as a second direction.

In the printed circuit board provided in this embodiment of this application, the solder pad row is disposed on the back of the circuit board body, and the solder pad row includes the plurality of pin solder pads and the solder thief pad that are successively disposed at intervals in the first direction. Therefore, during wave soldering, with the back of the circuit board body downward, the circuit board body is pulled to move upward in a direction opposite to the first direction at a tilt angle of 6° to 8, to pass through a solder wave, so that the plurality of pin solder pads and the solder thief pad successively pass through the solder wave. In this way, the solder thief pad can attract soldering tin on the end pin solder pad to the solder thief pad, to prevent soldering tin from accumulating on the end pin solder pad. Compared with the prior art, on the premise that the pin solder pads are round, the outline of the edge, on the solder thief pad, that is close to the plurality of pin solder pads is an arc concave toward the solder thief pad, so that on the premise that an interstice width between a middle part of the solder thief pad and the end pin solder pad in the second direction remains unchanged, an interstice between either of two ends of the solder thief pad in the second direction and the end pin solder pad is relatively small. Therefore, during wave soldering, the two ends of the solder thief pad in the second direction exert relatively strong acting force on the end pin solder pad, and soldering tin on the end pin solder pad can be effectively attracted to the solder thief pad. This reduces a possibility of generating soldering tin paste between the end pin solder pad and an adjacent pin solder pad in a same row, and between the end pin solder pad and a pin solder pad in an adjacent row, and avoids a short circuit on the printed circuit board.

Optionally, a circle center of the arc coincides with a center of the end pin solder pad. In this way, interstice widths between positions on the solder thief pad in the second direction and the end pin solder pad are equal to each other, so that the solder thief pad can evenly attract soldering tin on the end pin solder pad, to further reduce the possibility of generating soldering tin paste between the end pin solder pad and the adjacent pin solder pad in the same row, and between the end pin solder pad and the pin solder pad in the adjacent row.

Optionally, a minimum interstice width between the solder thief pad and the end pin solder pad is a first interstice width, and a minimum interstice width between two adjacent pin solder pads is a second interstice width. The first interstice width is equal to the second interstice width. In this way, the minimum interstice width between the solder thief pad and the end pin solder pad is moderate. Therefore, soldering tin on the end pin solder pad can be effectively attracted to the solder thief pad, and soldering tin paste between the solder thief pad and the end pin solder pad caused by an excessively small interstice width can be avoided.

Optionally, a maximum width of the solder thief pad in the first direction is 2 to 4 times a maximum width of the pin solder pad in the first direction. In this way, the width of the solder thief pad in the first direction is moderate. Therefore, soldering tin on the end pin solder pad can be effectively attracted to the solder thief pad, and an increased area occupied by the solder thief pad and an increased volume of the printed circuit board that are caused by an excessively large maximum width of the solder thief pad in the first direction can be avoided.

Optionally, there are a plurality of solder pad rows, and the plurality of solder pad rows are disposed side by side in the second direction. In this way, soldering tin on end pin solder pads in the plurality of solder pad rows is respectively attracted by solder thief pads in the plurality of solder pad rows. This can avoid soldering tin paste generated between end pin solder pads in two adjacent solder pad rows.

Optionally, the pin solder pads in the plurality of solder pad rows are arranged in a staggered manner in the second direction. In this way, on the premise that a minimum interstice width between pin solder pads in two adjacent solder pad rows remains unchanged, a distance between two adjacent solder pad rows is reduced. This helps to reduce an area occupied by the plurality of solder pad rows on the back of the circuit board body, and further helps to reduce the volume of the printed circuit board.

Optionally, the solder thief pads in the plurality of solder pad rows are successively integrated into an integrated solder thief pad in the second direction. In this way, the printed circuit board has a relatively small quantity of solder pads and a simple structure, and is easy to produce. In addition, no interstice exists between two adjacent solder thief pads, and therefore, soldering tin on two adjacent end pin solder pads can be more effectively attracted to the solder thief pads, to avoid soldering tin paste generated between the two adjacent end pin solder pads.

Optionally, in the second direction, a beginning edge of a pin solder pad in the first solder pad row is a first edge, an end edge of the pin solder pads in the last solder pad row is a second edge, and an interstice width between the first edge and the second edge is a third interstice width. In this case, a width of the integrated solder thief pad in the second direction is equal to the third interstice width. In this way, the width of the integrated solder thief pad in the second direction is moderate, this avoids excessively large space occupied by the solder thief pad that is caused by an excessive width of the integrated solder thief pad in the second direction, and soldering tin on the end pin solder pads in the plurality of solder pad rows can be effectively attracted, to effectively avoid a short circuit caused by soldering tin paste generated between a plurality of end pin solder pads.

Optionally, edges that are of solder thief pads in the plurality of solder pad rows and that are away from the pin solder pad are flush with each other. In this way, end edges of the plurality of solder pad rows in the first direction are flush with each other, facilitating arrangement of the plurality of solder pad rows on the back of the circuit board body.

According to a second aspect, this application provides a terminal, including a printed circuit board, and the printed circuit board is the printed circuit board according to any one of the foregoing technical solutions.

The terminal provided in this embodiment of this application includes a printed circuit board, and the printed circuit board is the printed circuit board according to any one of the foregoing technical solutions. Therefore, the terminal and the printed circuit board can resolve a same technical problem, and achieve a same expected effect.

### BRIEF DESCRIPTION OF DRAWINGS

FIG. 1 is a schematic structural diagram of a printed circuit board in the prior art;
FIG. 2 is a schematic structural diagram of a printed circuit board in FIG. 1 during wave soldering;
FIG. 3 is a schematic structural diagram of a printed circuit board in FIG. 1 after wave soldering;
FIG. 4 is another schematic structural diagram of a printed circuit board in FIG. 1 after wave soldering;
FIG. 5 is a schematic structural diagram of another printed circuit board in the prior art;
FIG. 6 is a first schematic structural diagram of a printed circuit board according to an embodiment of this application;
FIG. 7 is a second schematic structural diagram of a printed circuit board according to an embodiment of this application;
FIG. 8 is a third schematic structural diagram of a printed circuit board according to an embodiment of this application;
FIG. 9 is a fourth schematic structural diagram of a printed circuit board according to an embodiment of this application;
FIG. 10 is a fifth schematic structural diagram of a printed circuit board according to an embodiment of this application;
FIG. 11 is a sixth schematic structural diagram of a printed circuit board according to an embodiment of this application; and
FIG. 12 is a seventh schematic structural diagram of a printed circuit board according to an embodiment of this application.

### DESCRIPTION OF EMBODIMENTS

The following describes the technical solutions in the embodiments of this application with reference to the accompanying drawings in the embodiments of this application.

FIG. 6 is a printed circuit board according to an embodiment of this application. Referring to FIG. 6, the printed circuit board provided in this embodiment includes a circuit board body 1 and a solder pad row 2 disposed on a back of the circuit board body 1. The solder pad row 2 includes a solder thief pad 4 and a plurality of pin solder pads 3. The plurality of pin solder pads 3 and the solder thief pad 4 are successively disposed at intervals in a first direction K₁. The pin solder pads 3 are round. An outline of an edge 5, on the solder thief pad 4, that is close to the plurality of pin solder pads 3 is an arc concave toward the solder thief pad 4.

It should be noted that, to facilitate the following analysis and description, a pin solder pad closest to the solder thief pad 4 in the plurality of pin solder pads 3 is defined as an end pin solder pad A. In addition, a direction perpendicular to the first direction K₁ and parallel to the back of the circuit board body 1 is defined as a second direction K₂.

In the printed circuit board provided in this embodiment of this application, the solder pad row 2 is disposed on the back of the circuit board body 1, and the solder pad row 2 includes the plurality of pin solder pads 3 and the solder thief pad 4 that are successively disposed at intervals in the first direction K₁. Therefore, during wave soldering, with the back of the circuit board body 1 downward, the circuit board body 1 is pulled to move upward in a direction opposite to the first direction K₁ at a tilt angle of 6° to 8°, to pass through a solder wave, so that the plurality of pin solder pads 3 and the solder thief pad 4 successively pass through the solder wave. In this way, the solder thief pad 4 can attract soldering tin on the end pin solder pad A to the solder thief pad 4, to prevent soldering tin from accumulating on the end pin solder pad A.

Compared with the prior art, on the premise that the pin solder pads 3 are round, the outline of the edge 5, on the solder thief pad 4, that is close to the plurality of pin solder pads 3 is an arc concave toward the solder thief pad 4, so that on the premise that an interstice width Di between a middle part of the solder thief pad 4 and the end pin solder pad A in the second direction K₂ is equal to b₂ in FIG. 5, an interstice width D₂ between either of two ends of the solder thief pad 4 in the second direction K₂ and the end pin solder pad Ais less than bi in FIG. 5. Therefore, during wave soldering, the two ends of the solder thief pad 4 in the second direction K₂ exert relatively strong acting force on the end pin solder pad A, and soldering tin on the end pin solder pad A can be effectively attracted to the solder thief pad 4. This reduces a possibility of generating soldering tin paste between the end pin solder pad A and an adjacent pin solder pad 3 in a same row, and between the end pin solder pad A and a pin solder pad 3 in an adjacent row, and avoids a short circuit on the printed circuit board.

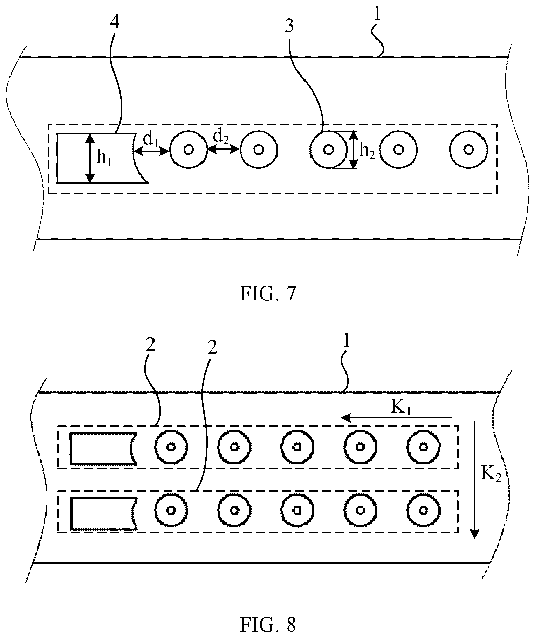

In the foregoing embodiment, a maximum width hi of the solder thief pad 4 in the second direction K₂ may be less than, equal to, or greater than a maximum width h₂ of the pin solder pads 3 in the second direction K₂. This is not specifically limited herein. For example, as shown in FIG. 7, the maximum width hi of the solder thief pad 4 in the second direction K₂ is greater than the maximum width h₂ of the pin solder pads 3 in the second direction K₂.

Either the first direction K₁ or the second direction K₂ may be parallel to the back of the circuit board body 1. This is not specifically limited herein, provided that the first direction K₁ and the second direction K₂ are perpendicular to each other.

In addition, a quantity of pin solder pads 3 included in the solder pad row 2 may be 2, 3, 4, or the like. This is not specifically limited herein.

In addition, a circle center of the arc may be located on a side, of the end pin solder pad A, that is close to the solder thief pad 4, or may be located on a side, of the end pin solder pad A, that is away from the solder thief pad 4, or may coincide with a center of the end pin solder pad A. This is not specifically limited herein.

Optionally, as shown in FIG. 6, the circle center of the arc coincides with the center of the end pin solder pad A. In this way, interstice widths between positions on the solder thief pad 4 in the second direction K₂ and the end pin solder pad A are equal to each other, so that the solder thief pad 4 can evenly attract soldering tin on the end pin solder pad A, to further reduce the possibility of generating soldering tin paste between the end pin solder pad A and the adjacent pin solder pad in the same row, and between the end pin solder pad A and the pin solder pad 3 in the adjacent row.

In the embodiment shown in FIG. 7, if a minimum interstice width between the solder thief pad 4 and the end pin solder pad A is defined as a first interstice width di, and a minimum interstice width between two adjacent pin solder pads 3 is defined as a second interstice width d₂, the first interstice width d₁ may be greater than the second interstice width d₂, or may be less than the second interstice width d₂, or may be equal to the second interstice width d₂. This is not specifically limited herein.

Optionally, the first interstice width d₁ is equal to the second interstice width d₂. In this way, the minimum interstice width between the solder thief pad 4 and the end pin solder pad A is moderate. Therefore, soldering tin on the end pin solder pad A can be effectively attracted to the solder thief pad 4. In addition, soldering tin paste generated between the solder thief pad 4 and the end pin solder pad A caused by an excessively small width of the interstice can be avoided, thereby reducing a possibility of short-circuit on the end pin solder pad A.

As shown in the embodiment of FIG. 6, a maximum width w₁ of the solder thief pad 4 in the first direction K₁ may be 1 time, 1.5 times, 2 times, or 3 times a maximum width w₂ of the pin solder pad 3 in the first direction K₁. This is not specifically limited herein. Optionally, the maximum width w₁ of the solder thief pad 4 in the first direction K₁ is 2 to 4 times the maximum width w₂ of the pin solder pad 3 in the first direction K₁. In this way, the width w₁ of the solder thief pad 4 in the first direction K₁ is moderate. Therefore, soldering tin on the end pin solder pad A can be effectively attracted to the solder thief pad 4, and an increased area occupied by the solder thief pad 4 and an increased volume of the printed circuit board that are caused by an excessively large maximum width of the solder thief pad 4 in the first direction K₁ can be avoided.

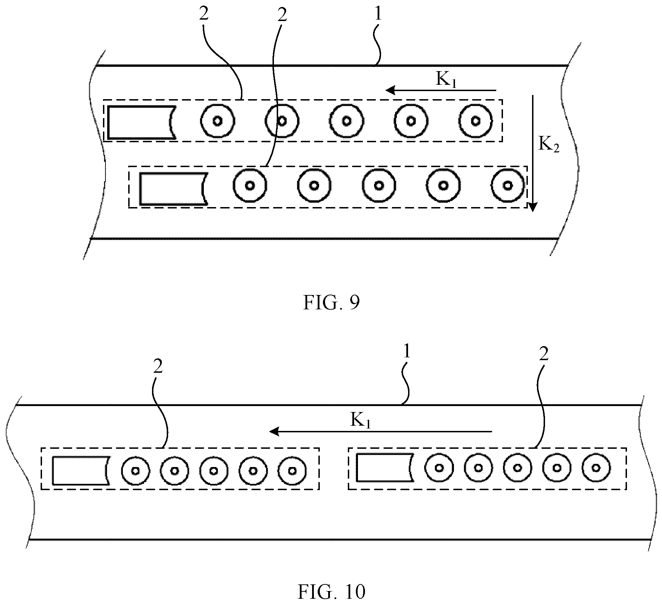

In the embodiment shown in FIG. 6, there may be one or more solder pad rows 2. This is not specifically limited herein. In addition, when there are a plurality of solder pad rows 2, the plurality of solder pad rows 2 may be arranged in the first direction K₁ (as shown in FIG. 10), or may be arranged in the second direction K₂ (as shown in FIG. 8 or FIG. 9). This is not specifically limited herein. When there are a plurality of solder pad rows 2, specifically, there may be two solder pad rows 2 as shown in FIG. 8, FIG. 9, FIG. 10, FIG. 11, and FIG. 12, or there may be three rows, four rows, or the like. This is not specifically limited herein.

Optionally, as shown in FIG. 8 or FIG. 9, there are a plurality of solder pad rows 2, and the plurality of solder pad rows 2 are disposed side by side in the second direction K₂. In this way, soldering tin on end pin solder pads A in the plurality of solder pad rows 2 is respectively attracted by solder thief pads 4 in the plurality of solder pad rows 2. This can avoid soldering tin paste generated between end pin solder pads A in two adjacent solder pad rows 2.

In the embodiment shown in FIG. 8 or FIG. 9, the pin solder pads in the plurality of solder pad rows 2 may be arranged in an orderly manner in the second direction K₂ (as shown in FIG. 8), or may be arranged in a staggered manner in the second direction K₂ (as shown in FIG. 9). This is not specifically limited herein.

Optionally, as shown in FIG. 9, the pin solder pads 3 in the plurality of solder pad rows 2 are arranged in a staggered manner in the second direction K₂. In this way, on the premise that a minimum interstice width between pin solder pads in two adjacent solder pad rows 2 remains unchanged, a distance between two adjacent solder pad rows 2 is reduced. This helps to reduce an area occupied by the plurality of solder pad rows 2 on the back of the circuit board body 1, and further helps to reduce the volume of the printed circuit board.

In the embodiment shown in FIG. 8 or FIG. 9, the solder thief pads 4 in the plurality of solder pad rows 2 may be disposed at intervals, or may be successively integrated into an integrated structure in the second direction K₂. This is not specifically limited herein.

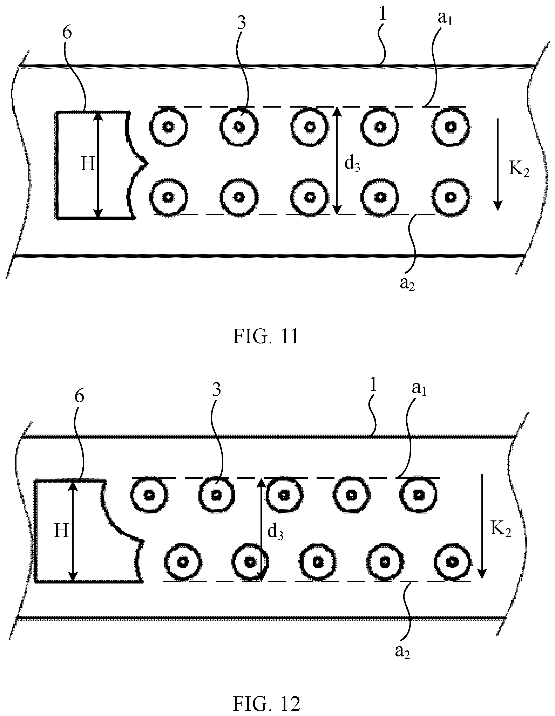

Optionally, as shown in FIG. 11 or FIG. 12, the solder thief pads in the plurality of solder pad rows 2 are successively integrated into an integrated solder thief pad 6 in the second direction. In this way, the printed circuit board has a relatively small quantity of solder pads and a simple structure, and is easy to produce. In addition, no interstice exists between two adjacent solder thief pads, and therefore, soldering tin on two adjacent end pin solder pads can be more effectively attracted to the solder thief pads, to avoid soldering tin paste generated between the two adjacent end pin solder pads.

In the embodiment shown in FIG. 11 or FIG. 12, in the second direction K₂, a beginning edge of a pin solder pad 3 in the first solder pad row 2 is defined as a first edge ai, an end edge of a pin solder pad 3 in the last solder pad row 2 is defined as a second edge a₂, and an interstice width between the first edge and the second edge is a third interstice width d₃. In this case, a width H of the integrated solder thief pad 6 in the second direction K₂ may be greater than, less than, or equal to the third interstice width d₃. This is not specifically limited herein.

Optionally, the width H of the integrated solder thief pad 6 in the second direction K₂ is equal to the third interstice width d₃. In this way, the width H of the integrated solder thief pad 6 in the second direction K₂ is moderate, this avoids excessively large space occupied the solder thief pad that is caused by an excessive width of the integrated solder thief pad 6 in the second direction K₂, and soldering tin on the end pin solder pads in the plurality of solder pad rows 2 can be effectively attracted, to effectively avoid a short circuit caused by soldering tin paste generated between a plurality of end pin solder pads.

In the embodiment shown in FIG. 8, FIG. 9, FIG. 11, or FIG. 12, edges that are of solder thief pads in the plurality of solder pad rows and that are away from the pin solder pad 3 may be flush with each other, or may be not flush with each other. This is not specifically limited herein. Optionally, as shown in FIG. 11 or FIG. 12, the edges that are of solder thief pads in the plurality of solder pad rows and that are away from the pin solder pad 3 are flush with each other. In this way, end edges of the plurality of solder pad rows in the first direction are flush with each other, facilitating arrangement of the plurality of solder pad rows on the back of the circuit board body 1.

This application further provides a terminal, including a printed circuit board, and the printed circuit board is the printed circuit board according to any one of the foregoing technical solutions.

The terminal provided in the embodiment of this application includes a printed circuit board, and the printed circuit board is the printed circuit board according to any one of the foregoing technical solutions. Therefore, the terminal and the printed circuit board can resolve a same technical problem, and achieve a same expected effect.

In the foregoing embodiments, the terminal may be a mobile phone, a tablet computer, a watch, a camera, or the like. This is not specifically limited herein. Other composition of the terminal in the embodiments of this application is well known to a person skilled in the art, and details are not described herein.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A printed circuit board, comprising a circuit board body and a solder pad row disposed on a back of the circuit board body, wherein
the solder pad row comprises a solder thief pad and a plurality of pin solder pads, the plurality of pin solder pads and the solder thief pad are successively disposed at intervals in a first direction, wherein the pin solder pads are round, and an outline of an edge, on the solder thief pad, that is close to the plurality of pin solder pads is an arc concave toward the solder thief pad.

2. The printed circuit board according to claim 1, wherein a pin solder pad, in the plurality of pin solder pads, closest to the solder thief pad is an end pin solder pad, and a circle center of the arc coincides with a center of the end pin solder pad.

3. The printed circuit board according to claim 1 or 2, wherein a minimum interstice width between the solder thief pad and the end pin solder pad is a first interstice width, a minimum interstice width between two adjacent pin solder pads is a second interstice width, and the first interstice width is equal to the second interstice width.

4. The printed circuit board according to any one of claims 1 to 3, wherein a maximum width of the solder thief pad in the first direction is 2 to 4 times a maximum width of the pin solder pads in the first direction.

5. The printed circuit board according to any one of claims 1 to 4, wherein there are a plurality of solder pad rows, the plurality of solder pad rows are disposed side by side in a second direction, and the second direction is perpendicular to the first direction.

6. The printed circuit board according to claim 5, wherein the pin solder pads in the plurality of solder pad rows are disposed in a staggered manner in the second direction.

7. The printed circuit board according to claim 5 or 6, wherein solder thief pads in the plurality of solder pad rows are successively integrated into an integrated solder thief pad in the second direction.

8. The printed circuit board according to claim 7, wherein in the second direction, a beginning edge of the pin solder pads in the first solder pad row is a first edge, and an end edge of the pin solder pads in the last solder pad row is a second edge, an interstice width between the first edge and the second edge is a third interstice width, and a width of the integrated solder thief pad in the second direction is equal to the third interstice width.

9. The printed circuit board according to any one of claims 5 to 8, wherein edges that are of the solder thief pads in the plurality of solder pad rows and that are away from the pin solder pads are flush with each other.

10. A terminal, comprising a printed circuit board, wherein the printed circuit board is the printed circuit board according to any one of claims 1 to 9.
